# EUROPÄISCHE PATENTSCHRIFT

(11) **EP 0 821 476 B1**
(45) Veröffentlichungstag und Bekanntmachung des Hinweises auf die Patenterteilung: **12.03.2003**
(21) Anmeldenummer: 97112874.9
(22) Anmeldetag: 25.07.1997
(51) Int. Cl.: H03F 3/45, H03F 1/30

(54) **Vorrichtung zur Offset-Kompensation einer Signalverarbeitungsschaltung**
Device for offset compensation of a signal processing circuit
Dispositif de compensation de l'offset d'un circuit de traitement de signaux

(30) Priorität: 26.07.1996 DE 19630396
(43) Veröffentlichungstag der Anmeldung: 28.01.1998
(73) Patentinhaber: SGS-THOMSON MICROELECTRONICS GMBH, 85630 Grasbrunn (DE)
(72) Erfinder: Kirchlechner, Peter, 83104 Hohenthann (DE); Schambacher, Jörg, 81667 München (DE); Lübbe, Jürgen, 83553 Jacobneuharting (DE)
(74) Vertreter: Hirsch, Peter, Dipl.-Ing.

(56) Entgegenhaltungen:
- EP-A- 0 065 339
- EP-A- 0 297 818
- US-A- 4 356 450
- US-A- 5 046 107
- US-A- 5 061 900

## Beschreibung

Die Erfindung betrifft eine Vorrichtung zur Offset-Kompensation einer Signalverarbeitungsschaltung, in deren Signalweg sich eine Offset-behaftete Schaltungsanordnung befindet, gemäß dem Oberbegriff des Patentanspruchs 1.

Eine derartige Signalverarbeitungsschaltung ist im Zusammenhang mit einem als integrierte Schaltung ausgebildeten Präzisionsverstärker aus der US-A-5 061 900 bekannt. Dabei wird im Zusammenhang mit der Offset-Kompensation auf einen bezüglich der integrierten Schaltung externen Kondensator zurück gegriffen.

Eine Signalverarbeitungsschaltung gemäß dem Oberbegriff des Patentanspruchs 1 kann beispielsweise auch Teil eines Radiogerätes sein, dessen Audiosignalverarbeitungsschaltung wahl weise an eine von mehreren Audiosignalquellen anschließbar ist, bei denen es sich z.B. um einen Stereodecoder, eine AM-Signalquelle, einen Kassettenrecorder und einen
CD-Spieler handeln kann.

Im Bereich von Radiogeräten ist der Grad der monolithischen Integration sehr weit fortgeschritten. Unter der Bezeichnung TDA 7340 hat SGS-THOMSON eine monolithisch integrierte Schaltung herausgebracht, welche die gesamte Audiosignalverarbeitung eines Stereo-Radiogerätes durchführt. Für ihren Betrieb greift diese integrierte Schaltung auf eine Anzahl externer Schaltungskomponenten zurück, bei denen es sich vorwiegend um Kondensatoren handelt, die nicht oder nur mit sehr viel Aufwand monolithisch integrierbar sind. Für den Anschluß dieser externen Schaltungskomponenten benötigt diese integrierte Schaltung eine entsprechend hohe Anzahl von Anschlußstiften.

Im Eingangsbereich einer derartigen Audiosignalverarbeitungsschaltung, zu dem eine Schaltungseinrichtung zur selektiven Auswahl einer der Signalquellen und ein Signalverstärker mit einstellbarer Verstärkung gehören, befinden sich Offset-behaftete Schaltungskomponenten, nämlich der Stereodecoder und ein Operationsverstärker. Diesem Operationsverstärker folgt eine Schaltungsanordnung zur Ton- und Lautstärkesteuerung des mittels des Operationsverstärkers verstärkten Signals. In heutzutage üblicher Weise verwendet man sowohl für die Verstärkungseinstellung des Operationsverstärkers als auch für die Ton- und Lautstärkeeinstellung mittels der nachfolgenden Ton- und Lautstärke-Steuerschaltung mittels digitaler Steuersignale einstellbare Spannungsteiler in Form von Widerstandsketten mit einer Mehrzahl von Teilspannungsabgriffen. Derartige Spannungsteiler bringen anders als die früher verwendeten Potentiometer keine stufenlose Einstellbarkeit mit sich, sondern eine quantenmäßige Einstellbarkeit. Werden auf solche Spannungsteiler Audiosignale gegeben, denen aufgrund von vorausgehenden Offset-behafteten Schaltungsanordnungen eine Gleichspannungskomponente überlagert ist, wird auch diese von den digital steuerbaren Spannungsteilern quantenmäßig herabgestuft. Dies führt bei einer Veränderung der Einstellung eines solchen Spannungsteilers zu einem hörbaren Klicken des Lautsprechers eines mit einer derartigen Audiosignalverarbeitungsschaltung aus gerüsteten Radiogerätes.

Bei der bekannten Audiosignalverarbeitungsschaltung hat man dieses Problem dadurch überwunden, daß man zwischen den Ausgang des Operationsverstärkers, dessen Signaleingang mit der jeweils ausgewählten Signalquelle verbunden ist, und die nachfolgende Ton- und Lautstärkesteuerungsschaltung einen Kondensator in Reihe geschaltet hat, mit dem eine Gleichspannungs-Entkopplung und damit eine Eliminierung des Offset-Gleichspannungsanteils erreicht worden ist.

Durch eine Vielzahl von Maßnahmen ist es der Anmelderin gelungen, eine neue monolithisch integrierte Schaltung für Audiosignalverarbeitung zu schaffen, die mit erheblich weniger externen Schaltungskomponenten als bisher erforderlich auskommt, was zur Einsparung von 24 Anschlußstiften gegenüber der integrierten Schaltung TDA 7340 geführt hat Dies bringt eine erhebliche Kosteneinsparung mit sich, einerseits dadurch, daß für die integrierte Schaltung ein einfacheres Gehäuse verwendet werden kann, und andererseits dadurch, daß so viele externe Schaltungskomponenten eingespart werden können.

Im Rahmen der Realisierung dieser neuen integrierten Schaltung ist der Wunsch entstanden, den bei der bekannten Signalverarbeitungsschaltung für die Unterdrückung der Offset-Spannung verwendeten externen Kordensator überflüssig zu machen. Für ein Radiogerät, das für Stereoempfang geeignet ist und deshalb zwei Signalverarbeitungskanäle aufweist, bedeutet dies eine Einsparung von zwei externen Kondensatoren und vier Anschlußstiften der integrierten Signalverarbeitungsschaltung.

Mit der vorliegenden Erfindung sollte daher die Notwendigkeit derartiger externer Kondensatoren und der dafür benötigten Anschlußstifte beseitigt werden und deshalb eine Offset-Kompensationsmethode verfügbar gemacht werden, die nicht auf externe Schaltungskomponenten zurückgreifen muß.

Dies ist erfindungsgemäß mit einer elektrischen Signalverarbeitungsschaltung der in Patentanspruch 1 angegebenen Art erreicht worden. Bevorzugte Ausführungsformen der erfindungsgemäßen Signalverarbeitungsschaltung sind in den abhängigen Patentansprüchen angegeben.

Eine erfindungsgemäße Signalverarbeitungsschaltung, in deren Signalweg sich eine Offset-behaftete Schaltungsanordnung befindet, umfaßt zur Offset-Kompensation:
eine Schaltereinrichtung, mittels welcher die Offset-behaftete Schaltungsanordnung vorübergehend in einen Kompensationsbetriebszustand schaltbar ist, in dem sie von dem Signalweg der Signalverarbeitungsschaltung entkoppelt ist und in einem reinen Gleichspannungsbetrieb gehalten wird;
eine Addiereinrichtung, mittels welcher zu der Ausgangsspannung der Offset-behafteten Schaltungsanordnung eine Offset-Kompensationsspannung hinzuaddierbar ist;
einen Nullspannungsdetektor, mittels welchem die Ausgangsspannung der Addiereinrichtung auf das Auftreten eines Spannungswertes Null überwachbar ist; eine Kompensationsspannungsquelle, die zu Beginn eines Offset-Kompensationsvorgangs zunächst in einen ersten Betriebszustand, in dem sie eine ansteigende oder abfallende Kompensationsgleichspannung abgibt, und danach in einen zweiten Betriebszustand, in dem sie konstant die zum Zeitpunkt des Verlassens des ersten Betriebszustandes erreichte Kompensationsgleichspannung liefert, steuerbar ist;
und eine Kompensationssteuerschaltung, mittels welcher der Schaltzustand der Schaltereinrichtung steuerbar und die Kompensationsspannungsquelle zu Beginn eines Offset-Kompensationsvorgangs in ihren ersten Betriebszustand schaltbar ist;
wobei der Ausgang der Addiereinrichtung (45) direkt mit dem Eingang des Nullspannungsdetektors (57) verbunden ist und die Kompensationsspannungsquelle bei Feststellung eines Spannungswertes Null am Ausgang der Addiereinrichtung durch den Nullspannungsdetektor in ihren zweiten Betriebszustand schaltbar ist.

Bei einer bevorzugten Ausführungsform der erfindungsgemäßen Signalverarbeitungsschaltung sind in dem Signalweg der Signalverarbeitungsschaltung vor der Offset-behafteten Schaltungsanordnung ein erster steuerbarer Schalter und nach der Offset-behafteten Schaltungsanordnung ein zweiter steuerbarer Schalter angeordnet und ist die Addiereinrichtung zwischen der Offset-behafteten Schaltungsanordnung und dem zweiten steuerbaren Schalter angeordnet. Die beiden Schalter führen der je nachfolgenden Schaltungseinrichtung in einem ersten Schaltzustand das zu verarbeitende Signal und in einem zweiten Schaltzustand ein Null- oder Massepotential zu. Die Addierereinrichtung kann einen ersten Addierereingang aufweisen, der mit dem Ausgang der Offset-behafteten Schaltungsanordnung gekoppelt ist, einen zweiten Addierereingang, der mit einem Kompensationsspannungsausgang der Kompensationsspannungsquelle gekoppelt ist, und einen Addiererausgang, der einerseits mit dem zweiten Schalter und andererseits mit einem Eingang des Nullspannungsdetektors gekoppelt ist.

Die Steuerschaltung kann durch ein Offset-Kompensationsbefehlssignal in einen Offset-Kompensationsbetrieb steuerbar sein, indem sie die beiden steuerbaren Schalter je in einen den Signalweg unterbrechenden Schaltzustand und die Kompensationsspannungsquelle in deren ersten Betriebszustand steuert. Vom Nullspannungsdetektor kann bei der Feststellung eines Spannungswertes Null am Addiererausgang ein Stopsignal erzeugbar sein, auf welches hin die Kompensationsspannungsquelle in ihren zweiten Betriebszustand und die beiden steuerbaren Schalter in einen das Signal leitenden Schaltzustand steuerbar sind.

Liegt eine Audiosignalverarbeitungsschaltung mit einem Offset-behafteten Stereodecoder vor, wird der erste steuerbare Schalter im Signalweg vor dem Stereodecoder angeordnet.

Bei einer Audiosignalverarbeitungsschaltung, die eine Signalquellenauswahlschaltung aufweist, mittels welcher von einer Anzähl unterschiedlicher Audiosignalquellen, die mindestens eine Offset-behaftete Signalquelle, wie den Stereodecoder, und Offset-freie Signalquellen, beispielsweise Eingangsanschlüsse für einen Kassettenrecorder, einen CD-Spieler und eine AM-Signalquelle, umfassen, jeweils eine mit einem Signaleingang des Signalverstärkers verbindbar ist, kann die Schaltereinrichtung einen dritten steuerbaren Schalter aufweisen, der in dem Signalweg zwischen der Signalquellenauswahlschaltung und dem Signaleingang des Signalverstärkers angeordnet ist und dem Signaleingang des Signalverstärkers in einem ersten Schaltzustand das zu verarbeitende Signal und in einem zweiten Schaltzustand das Massepotential zuführt, wobei der dritte Schalter während eines Offset-Kompensationsvorganges in den ersten Schaltzustand schaltbar ist, wenn die Signalquellenauswahlschaltung den Signaleingang des Signalverstärkers mit der Offset-behafteten Signalquelle verbindet, und den zweiten Schaltzustand schaltbar ist, wenn die Signalquellenauswahlschaltung den Signaleingang des Signalverstärkers mit einer Offset-freien Signalquelle verbindet.

Die Kompensationsspannungsquelle kann einen mit Zähltakten beaufschlagbaren Zähler aufweisen, der zu Beginn eines Offset-Kompensationsvorgangs auf einen vorbestimmten Anfangszählwert einstellbar ist und dessen Zählwert während des ersten Betriebszustandes der Kompensationsspannungsquelle durch Zählen der Zähltakte veränderbar und während des zweiten Betriebszustandes der Kompensationsspannungsquelle auf dem zum Zeitpunkt des Verlassens des ersten Betriebszustandes erreichten Zählwert festhaltbar ist. In diesem Fall weist die Kompensationsspannungsquelle außerdem einen Digital/Analog-Wandler auf, mittels welchem der jeweilige Zählstand des Zählers in einen analogen Kompensationsgleichspannungswert umwandelbar ist.

Die Kompensationssteuerschaltung kann einen Steuersignaleingang aufweisen, dem ein Signalquellenauswahlsignal zuführbar ist, mittels welchem von der Kompensationssteuerschaltung im wesentlichen gleichzeitig eine Umschaltung der Schaltereinrichtung in deren für einen Offset-Kompensationsvorgang vorgesehenen Schaltzustand und der Kompensationsgleichspannungsquelle in deren ersten Betriebszustand steuerbar ist.

Vorzugsweise wird das der Signalquellenauswahlschaltung zur Signalquellenumschaltung zugeführte Signalquellenauswahlsignal gleichzeitig dem Steuersignaleingang der Kompensationssteuerschaltung zugeführt, sodaß die Umschaltung der Schaltung in einen Offset-Kompensationsvorgang automatisch bei jeder Signalquellenumschaltung erfolgt.

Die Kompensationssteuerschaltung kann ein Datenregister aufweisen, in dem ein die jeweils gewünschte Signalquelle bestimmendes Datenwort speicherbar ist, mittels welchem die gewünschte Signalquellenauswahl bis zum Einlesen eines neuen Datenwortes in das Datenregister aufrechterhaltbar ist. Außerdem kann die mittels der Steuereinrichtung auf den Empfang eines Datenwortes hin der Zähler auf den vorbestimmten Anfangszählstand setzbar ist. Der Zähler kann einen Stopsignaleingang aufweisen, dem das Stopsignal des Nullspannungsdetektors zuführbar ist, und der Zähler kann dabei dazu ausgebildet sein, bei dem beim Empfang des Stopsignals erreichten Zählwert stehenzubleiben, bis der Zähler von der Steuereinrichtung erneut auf seinen Anfangszählwert gesetzt wird.

Die Steuereinrichtung kann einen Stopsignaleingang aufweisen, dem das Stopsignal des Nullspannungsdetektors zuführbar ist, und sie kann dazu ausgebildet sein, beim Empfang des Stopsignals die Schaltereinrichtung in den signalleitenden Zustand zu steuern. In diesem Fall wird die Signalverarbeitungsschaltung aus dem Offset-Kompensationsvorgang in den normalen Signalverarbeitungszustand zurückgeschaltet, sobald während des Offset-Kompensationsvorgangs vom Nullspannungsdetektor festgestellt worden ist, daß die Gleichspannung am Addiererausgang zu Null geworden ist.

Man kann aber auch die Steuerschaltung derart ausbilden, daß sie die Signalverarbeitungsschaltung auf das Auslösen eines Offset-Kompensationsvorgangs hin für eine vorbestimmte Zeitdauer in dem Offset-Kompensationszustand hält und danach die Signalverarbeitungsschaltung in deren Signalverarbeitungszustand zurückschaltet, unabhängig von einem Ausgangssignal des Nullspannungsdetektors. Da in diesem Fall für den Offset-Kompensationsvorgang eine feste Zeitspanne vorgegeben werden muß, innerhalb welcher die Offset-Kompensation mit Sicherheit erreicht ist, kann es vorteilhaft sein, die Rückschaltung der Signalverarbeitungsschaltung aus dem Offset-Kompensationszustand in den normalen signalverarbeitenden Zustand vom Ausgangssignal des Nullspannungsdetektors abhängig zu machen.

Verwendet man die erfindungsgemäße Signalverarbeitungsschaltung für eine Audiosignalverarbeitungsschaltung der bereits erwähnten Art, bei welcher ein Signaleingang eines Signalverstärkers selektiv mit einer von mehreren Signalquellen verbindbar ist, kommt es beim Umschalten zwischen zwei Signalquellen vorübergehend zu einer Unterbrechung der Audiosignalverarbeitung, während welcher die Signalverarbeitungsschaltung üblicherweise in einen Stumm- oder Mute-Zustand geschaltet wird, um Umschaltgeräusche im Lautsprecherausgangssignal zu vermeiden. Die erfindungsgemäße Offset-Kompensation wird während dieses ohnehin vorhandenen Mute-Zustandes durchgeführt, so daß für den Benutzer des Audiogerätes der Offset-Kompensationsvorgang überhaupt nicht merkbar wird.

Da der am Ende eines Offset-Kompensationsvorganges erreichte Kompensationszustand aufrechterhalten bleibt, solange die jeweils gewählte Signalquelle nicht verlassen wird, reicht es aus, die Offset-Kompensationsvorgänge jeweils während der Signalquellenumschaltvorgänge durchzuführen.

Da diese Offset-Kompensation innerhalb der monolithisch integrierten Signalverarbeitungsschaltung stattfindet, also ohne Rückgriff auf externe Schaltungskomponenten, werden die im herkömmlichen Fall erforderlichen beiden Kondensatoren und vier Anschlußstifte nicht mehr benötigt.

Die Erfindung wird nun anhand einer Ausführungsform näher erläutert. In den Zeichnungen zeigen:
- **Fig. 1**: ein schematisches Schaltbild einer Ausführungsform einer erfindungsgemäßen Signalverarbeitungsschaltung; und
- **Fig. 2**: ein schematisches Blockschaltbild einer herkömmlichen Signalverarbeitungsleitung.

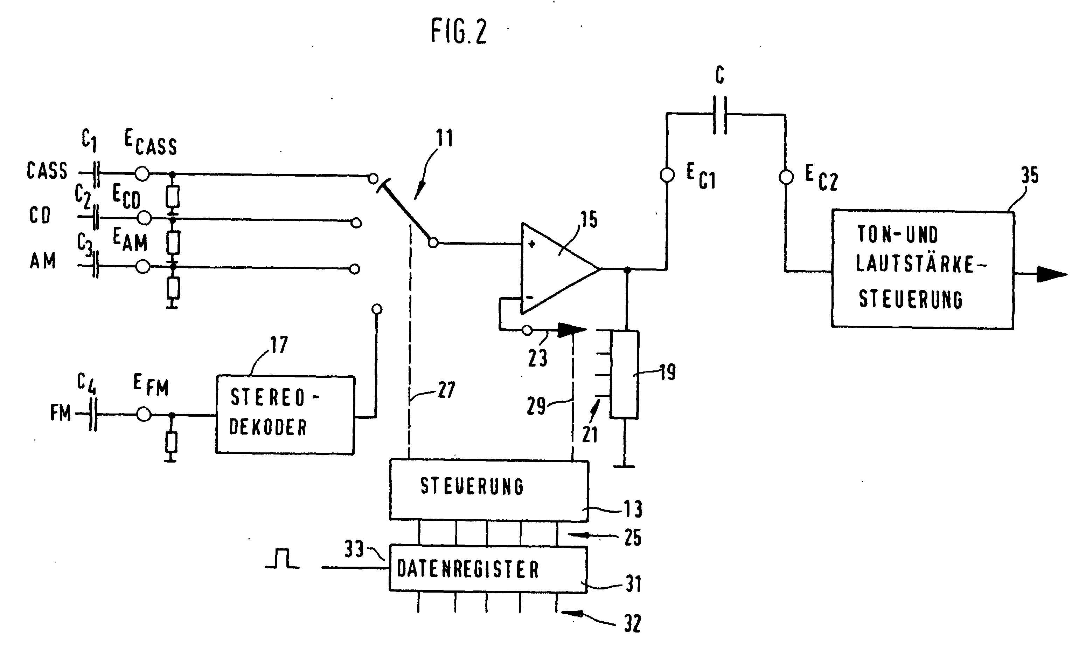

Zunächst wird anhand von Fig. 2 eine herkömmliche Signalverarbeitungsschaltung betrachtet. Diese weist vier Eingänge für vier verschiedene Audiosignalquellen auf, nämlich einen Eingang CASS, der mit einem Signalausgang eines Kassettenrecorders verbindbar ist, einen Signaleingang CD, der mit einem Signalausgang eines CD-(Compakt-Disk-) Spielers verbindbar ist, einen Signaleingang AM, der mit dem Ausgang einer AM-Signalquelle (Mittelwellen- und/oder Langwellen- und/oder Kurzwellenempfangsteil) verbunden ist, und einen Eingang FM, der mit einem FM-Stereo-Empfangsteil (für UKW-Stereo-Rundfunkempfang) verbunden ist. Die monolithisch integrierte Audiosignalverarbeitungsschaltung weist entsprechende Anschlußstifte E_{CASS}, E_{CD}, E_{AM} bzw. E_{FM} auf, mit denen die Signalverarbeitungsschaltung an diese Signalquellen anschließbar ist. Zwischen den Signalquellen und diesen Anschlußstiften der integrierten Schaltung befinden sich Kondensatoren C1 bis C4, mittels welchen eine Gleichspannungsentkopplung der genannten Anschlußstifte von den zugehörigen Signalquellen stattfindet, so daß Gleichspannungskomponenten, die möglicherweise von diesen Signalquellen geliefert werden, nicht auf die Anschlußstifte der integrierten Signalverarbeitungsschaltung übertragen werden.

Die Signalverarbeitungsschaltung weist eine Signalquellenauswahlschaltung auf, die einen Wählschalter 11, und eine die Auswahlstellung des Wählschalters 11 steuernde Steuerschaltung 13 umfaßt. Über den Wählschalter 11, der in Fig. 2 symbolisch als mehrstufiger Umschalter gezeigt ist, in der Praxis jedoch durch elektronische Schalter, insbesondere in Form von Schalttransistoren, gebildet ist, ist ein Signaleingang + eines Operationsverstärkers 15 in wählbarer Weise mit einem der vier Anschlußstifte E_{CASS} bis E_{FM} der integrierten Signalverarbeitungsschaltung verbindbar. Zwischen den Wählschalter 11 und den Anschlußstift E_{FM} ist ein Stereodecoder 17 geschaltet, an dessen Ausgang ein Audiosignal für einen von zwei Stereo-Kanälen zur Verfügung gestellt wird.

Der Operationsverstärker 15 weist einen Rückkopplungskreis auf, in dem sich ein Spannungsteiler 19 in Form einer Widerstandskette mit einer Anzahl Teilspannungsabgriffen 21 befindet. Jeder dieser Teilspannungsabgriffe ist über einen elektronischen Schalter 23, von denen der Einfachheit halber nur einer dargestellt ist, mit einem Rückkopplungseingang - des Operationsverstärkers 15 verbunden. In Abhängigkeit davon, welcher dieser elektrischen Schalter 23 leitend geschaltet ist, kann die Signalverstärkung des Operationsverstärkers 15 eingestellt werden. Diese Verstärkungseinstellung erfolgt ebenfalls unter Steuerung der Steuerschaltung 13, mittels welcher in Abhängigkeit von einem ihr zugeführten digitalen Steuersignal bestimmt wird, welcher der elektronischen Schalter 23 jeweils leiten soll.

Die Steuerschaltung 13 setzt digitale Steuerdatenwörter, die ihr über Eingangsanschlüsse 25 zugeführt werden, in Wählsignale für den Wählschalter 11 bzw. Schaltsteuersignale für die elektronischen Schalter 23 um. Die Steuersignalverbindungen zwischen der Steuerschaltung 13 und dem Wählschalter 11 einerseits und den elektronischen Schaltern 23 sind vereinfachend je durch eine gestrichelte Leitungsanordnung 27 bzw. 29 angedeutet.

Die Steuerschaltung 13 erhält ihre Steuerdatenwörter von einem Datenregister 31, das Dateneinleseleitungen 32 und einen Einlesesteuereingang 33 aufweist. In das Datenregister 31 wird jedesmal dann, wenn auf eine andere Signalquelle umgeschaltet werden soll, ein zu dieser Signalquelle gehörendes Datenwort eingelesen. Dieses bleibt im Datenregister 31 gespeichert, bis erneut ein Steuersignal zur Auswahl einer der Signalquellen an den Einlesesteuereingang 33 geliefert wird. Das im Datenregister 31 gespeicherte Datenwort enthält einerseits Information über die zu der gewählten Signaleinrichtung gehörende Schaltstellung des Wählschalters 11 und andererseits Information darüber, welcher der elektronischen Schalter 23 für die gewählte Signalquelle leitend geschaltet werden soll. Auf diese Weise kann man jeder Signalquelle eine bestimmte Signalverstärkung durch den Operationsverstärker 15 zuordnen, beispielsweise um zu erreichen, daß das Audiosignal, das vom Ausgang des Operationsverstärkers 15 geliefert wird, einen Signalpegel aufweist, der im wesentlichen davon unabhängig ist, welche der Signalquellen gerade gewählt ist. Dies vermeidet unangenehme Lautstärkesprünge beim Umschalten auf eine andere Signalquelle.

Das vom Ausgang des Operationsverstärkers 15 gelieferte Audiosignal wird von einer Ton- und Lautstärkesteuerungsschaltung 35 weiterverarbeitet, mittels welcher die Tonstärke und Höhen und Tiefen des Audiosignals einstellbar sind.

Sowohl der Stereodecoder 17 als auch der Operationsverstärker 15 sind Offset-behaftet, erzeugen also eine unerwünschte Gleichspannungskomponente, die dem von ihnen gelieferten Audiosignal überlagert wird. Eine derartige Gleichspannungskomponente würde, wie bereits erwähnt, bei einer Veränderung der Ton- und/oder Lautstärkeeinstellung zu einem hörbaren Klicken in dem von den Lautsprechern abgestrahlten Schallsignal führen. Aus diesem Grund ist zwischen den Ausgang des Operationsverstärkers 15 und den Eingang der Ton- und Lautstärkesteuerungsschaltung 35 ein externer Kondensator C geschaltet, der mit der integrierten Audiosignalverarbeitungsschaltung über Anschlußstifte E_{C1} und E_{C2} verbunden ist.

Wie bereits erwähnt worden ist, sollen dieser Kondensator C und die Anschlußstifte E_{C1} und E_{C2} überflüssig gemacht werden, ohne daß sich das Offset-Verhalten von Stereodecoder 17 und/oder Operationsverstärker 15 in den nachfolgenden Signalverarbeitungsschaltungen auswirken können.

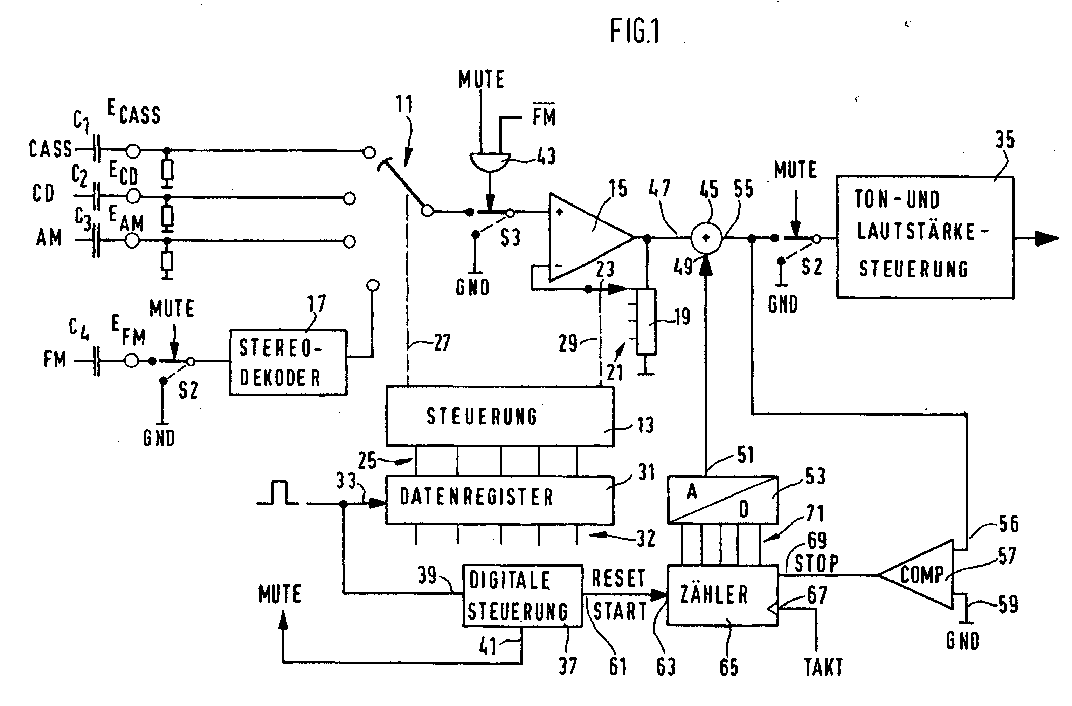

Dies wird mit der in Fig. 1 gezeigten Ausführungsform einer erfindungsgemäßen Signalverarbeitungsschaltung erreicht. Diese umfaßt sämtliche Schaltungskomponenten der in Fig. 2 gezeigten bekannten Signalverarbeitungsschaltung, mit Ausnahme des Kondensators C und der beiden Anschlußstifte E_{C1} und E_{C2}. Schaltungskomponenten, hinsichtlich derer die in Fig. 1 gezeigte Signalverarbeitungsschaltung mit der in Fig. 2 gezeigten Signalverarbeitungsschaltung übereinstimmt, sind mit den gleichen Bezugszeichen wie in Fig. 2 versehen und haben die gleiche Funktion, die im Zusammenhang mit Fig. 1 nicht nochmals erläutert wird.

Zusätzlich zu den in Fig. 2 gezeigten Schaltungskomponenten weist die in Fig. 1 dargestellte Signalverarbeitungsschaltung einen zwischen dem Anschlußstift E_{FM} und dem Stereodecoder 17 im Signalweg angeordneten ersten steuerbaren Schalter S1, einen zwischen dem Ausgang des Operationsverstärkers 15 und dem Eingang der Ton- und Lautstärkesteuerschaltung 35 in den Signalweg geschalteten zweiten steuerbaren Schalter S2 und einen zwischen den Wählschalter 11 und den Signaleingang des Operationsverstärkers 15 in den Signalweg geschalteten dritten steuerbaren Schalter S3 auf. Jeder dieser drei Schalter S1 bis S3 ist durch einen elektronischen Schalter gebildet, der in einem ersten Schaltzustand, der in Fig. 1 mittels einer durchgezogenen dicken Linie dargestellt ist, für das zu verarbeitende Audiosignal leitend und in einem zweiten Schaltzustand, der in Fig. 1 gestrichelt dargestellt ist, für das zu verarbeitende Audiosignal nicht leitend ist. Die Schalter S1 bis S3 stehen unter Steuerung einer digitalen Steuereinrichtung 37, die einen Steuersignaleingang 39 und einen Steuersignalausgang 41 aufweist. Dem Steuersignaleingang 39 wird jedesmal dann, wenn von der eingestellten Signalquelle auf eine andere Signalquelle umgeschaltet werden soll, ein Steuersignal zugeführt, das zur Abgabe eines MUTE-Signals am Steuersignalausgang 41 führt. Mit Hilfe des MUTE-Signals wird einerseits während des Signalquellenumschaltvorgangs eine Stummschaltung der Signalverarbeitungsschaltung und andererseits eine Umschaltung der Schalter S1 und S2 in denjenigen Schaltzustand, in welchem sie für das Audiosignal nicht leitend sind, bewirkt. In diesem Schaltzustand stellen die Schalter S1 und S2 je eine Verbindung zu einem Masseanschluß GND her.

Dem Steueranschluß des Schalters S3 wird das MUTE-Signal nicht direkt sondern über einen ersten Eingang einer UND-Schaltung 43 zugeführt, die einen zweiten Eingang aufweist, an den ein Signal FM geliefert wird. Das Signal FM ist derart bemessen, daß es die UND-Schaltung 43 für das MUTE-Signal nur dann durchlässig macht, wenn der Wählschalter 11 mit einer anderen Signalquelle als dem Stereodecoder 17 verbunden ist. Dies führt dazu, daß der Signaleingang + des Operationsverstärkers 15 dann, wenn der Stereodecoder 17 als Signalquelle ausgewählt ist, trotz des Auftretens eines MUTE-Signals mit dem Wählschalter 11 verbunden bleibt, und daß dann, wenn eine andere Signalquelle als der Stereodecoder 17 ausgewählt ist, der Signaleingang + des Operationsverstärkers 15 mit Masse GND verbunden ist.

Zwischen den Ausgang des Operationsverstärkers 15 und den zweiten Schalter S2 ist eine Addierschaltung 45 geschaltet, die einen ersten Eingang 47 aufweist, der mit dem Ausgang des Operationsverstärkers 15 verbunden ist, und die einen zweiten Eingang 49 aufweist, der mit einem Analogspannungsausgang 51 eines Analog/Digital-Wandlers (A/D-Wandlers) 53 verbunden ist. Ein Addiererausgang 55 ist einerseits mit dem zweiten Schalter S2 und andererseits mit einem ersten Komparatoreingang 56 eines Komparators 57 verbunden. Ein zweiter Eingang 59 des Komparators 57 ist mit Masse GND verbunden.

Die digitale Steuereinrichtung 37 weist einen Zählersteuerausgang 61 auf, der mit einem Zählersteuereingang 63 eines Zählers 65 verbunden ist, dem über einen Zähleingang 67 ein Zähltaktsignal TAKT zugeführt wird. Der Zähler weist außerdem einen Stopsignaleingang 69 auf, der mit einem Ausgang des Komparators 57 verbunden ist. Der A/D-Wandler 53 und der Zähler 65 sind über Zählwertleitungen 71 miteinander verbunden, über welche der vom Zähler 65 jeweils eingenommene Zählwert in digitaler Weise an den A/D-Wandler 53 lieferbar ist, der daraus eine dem jeweiligen Zählwert entsprechende Analogspannung erzeugt und dem zweiten Eingang 49 der Addierschaltung 45 als Offset-Kompensationsspannung zuführt.

Es wird nun die Funktionsweise der in Fig. 1 gezeigten Signalverarbeitungsschaltung betrachtet.

Zunächst wird angenommen, daß die Audiosignalverarbeitungsschaltung gerade auf den CD-Spieler als Signalquelle umgeschaltet werden soll. Um dies zu erreichen, betätigt der Benutzer des mit der Signalverarbeitungsschaltung der Fig. 1 versehenen Radiogerätes eine (nicht gezeigte) Auswahltaste. Dies führt dazu, daß in das Datenregister 31 ein Datenwort eingelesen wird, das einerseits den Wählschalter 11 in eine Verbindung mit dem Anschlußstift E_{CD} und andererseits eine bestimmte Verstärkung des Operationsverstärkers 15 steuert. Die Anweisung zur Umschaltung auf eine andere Signalquelle wird außerdem von der digitalen Steuereinrichtung 37 registriert, die daraufhin ein MUTE-Signal abgibt. Dieses bewirkt einerseits eine Stummschaltung des Radiogerätes und andererseits ein Umschalten der Schalter S1 und S2 auf deren Masseanschlüsse GND. Da der Wählschalter 11 nicht mit dem Stereodecoder 17 verbunden ist, gelangt an den Eingang FM der UND-Schaltung 43 ein Signal, welches diese UND-Schaltung 43 für das MUTE-Signal durchlässig macht, so daß der Signaleingang + des Operationsverstärkers 15 mit dem Masseanschluß GND des Schalters S3 verbunden wird. Der Operationsverstärker 15 ist somit aus dem Audiosignalweg ausgekoppelt. Gleichspannungsmäßig bleibt er aber in Betrieb.

Gleichzeitig mit der Abgabe des MUTE-Signals stellt die digitale Steuereinrichtung 37 den Zähler 65 über dessen Zählersteuereingang 63 auf einen vorbestimmten Anfangszählwert, vorzugsweise auf einen Anfangszählwert Null, und gibt dem Zähler ein Zählstartsignal, woraufhin dieser beginnt, das seinem Zähleingang 67 zugeführte Taktsignal TAKT zu zählen. Dies hat zur Folge, daß der A/D-Wandler 53 über seinen Ausgang 51 an den zweiten Eingang 49 der Addierschaltung 45 eine sich ändernde, nämlich zunehmende oder abnehmende, Analogspannung zuführt, welche die Funktion der Offset-Kompensationsgleichspannung hat. Diese Analogspannung wird zu der Gleichspannung am Ausgang des Operationsverstärkers 15, bei welcher es sich um dessen Offset-Spannung handelt, hinzugefügt oder von dieser subtrahiert. Die sich daraus am Addiererausgang 55 ergebende Gleichspannung wird vom Komparator 57 überwacht.

Wenn bekannt ist, welches Vorzeichen die vom Operationsverstärker 15 erzeugte Offset-Spannung hat, kann man den Zähler in einer solchen Richtung zählen lassen, daß die vom A/D-Wandler 53 gelieferte Analogspannung eine entgegengesetztes Vorzeichen aufweisende sich ändernde Gleichspannung ist. Geht man davon aus, daß der Operationsverstärker 15 eine Offset-Spannung positiven oder negativen Vorzeichens haben kann, kann man den Zähler von einem vorbestimmten Anfangszählstand eines ersten Vorzeichens über den Zählstand Null hinaus zu Zählwerten des entgegengesetzten Vorzeichens zählen lassen, so daß die vom A/D-Wandler 53 gelieferte Analogspannung von einem vorbestimmten Gleichspannungswert eines ersten Vorzeichens über den Gleichspannungswert Null hinaus zu Gleichspannungswerten des entgegengesetzten Vorzeichens läuft.

Sobald der Komparator 57 einen Gleichspannungswert Null am Addiererausgang 55 feststellt, liefert er über seinen Ausgang ein Stopsignal an den Zähler 65, was dazu führt, daß der Zähler 65 zu zählen aufhört und bei seinem bis dahin erreichten Zählstand stehenbleibt. Von diesem Zeitpunkt ab liefert der A/D-Wandler 53 daher eine gleichbleibende Offset-Kompensationsgleichspannung an den zweiten Eingang 49 der Addiererschaltung 45, was zu einer bleibenden Kompensation der Offset-Spannung des Operationsverstärker 15 führt. Diese Offset-Kompensation bleibt unverändert aufrechterhalten bis zu einer erneuten Signalquellenumschaltung.

Die Schalter S1 und S2 werden entweder beim Auftreten des Stopsignals am Ausgang des Komparators 57 in ihren Normalzustand zurückgeschaltet, indem sie das zu verarbeitende Audiosignal leiten, oder durch ein anderes Steuersignal am Ende des Signalquellenumschaltvorgangs.

Wird bei einem Auswahlvorgang der Stereodecoder 17 als Signalquelle ausgewählt, gelangt an den Eingang FM der UND-Schaltung 43 ein Binärsignal, das die UND-Schaltung 43 für das MUTE-Signal sperrt, so daß nur die Schalter S1 und S2 auf ihren Masseanschluß GND umgeschaltet werden, der Schalter S3 dagegen in demjenigen Zustand verbleibt, in welchem er den Signaleingang + des Operationsverstärkers 15 mit dem Wählschalter 11 verbindet. In diesem Fall befinden sich daher der Stereodecoder 17 und der Operationsverstärker 15 in einer Reihenschaltung, die aufgrund der Umschaltung von S1 und S2 insgesamt aus dem Signalweg ausgekoppelt ist. Am Ausgang des Operationsverstärkers 15 entsteht daher eine Gleichspannung, welche sich aus einer Summierung der Offset-Spannungen von Stereodecoder 17 und Operationsverstärker 15 ergibt. Bei dem durch das Umschalten des Wählschalters 11 auf den Stereodecoder 17 ausgelösten Offset-Kompensationsvorgang wird daher der Zählvorgang des Zählers 65 solange durchgeführt, bis die vom A/D-Wandler 53 gelieferte entsprechende Kompensationsgleichspannung einen solchen Wert erreicht hat, daß sie sowohl die Offset-Spannung des Stereodecoders 17 als auch die Offset-Spannung des Operationsverstärkers 15 kompensiert. Wenn sich dann nach Abschluß dieses Offset-Kompensationsvorgangs wieder alle drei Schalter S1 bis S3 im signalleitenden Zustand befinden, ist das am Addiererausgang 45 auftretende Audiosignal sowohl hinsichtlich der Offset-Spannung des Stereodecoders 17 als auch hinsichtlich der Offset-Spannung des Operationsverstärkers 15 kompensiert.

## Patentansprüche

1. Elektrische Signalverarbeitungsschaltung, in deren Signalweg sich eine Offset-behaftete Schaltungsanordnung (15, 17) befindet, wobei zur Offset-Kompensation vorgesehen sind:
a) eine Schaltereinrichtung (S1 - S3), mittels welcher die Offset-behaftete Schaltungsanordnung (15, 17) vorübergehend in einen Kompensationsbetriebszustand schaltbar ist, in dem sie von dem Signalweg der Signalverarbeitungsschaltung entkoppelt ist und in einem reinen Gleichspannungsbetrieb gehalten wird;
b) eine Addiereinrichtung (45), mittels welcher zu einer ersten Ausgangsspannung eine Offset-Kompensationsspannung hinzuaddierbar ist;
c) einen Nullspannungsdetektor (57), mittels welchem eine zweite Ausgangsspannung auf das Auftreten eines Spannungswertes Null überwachbar ist;
d) eine Kompensationsspannungsquelle (53, 65), die zu Beginn eines Offset-Kompensationsvorgangs zunächst in einen ersten Betriebszustand, in dem sie eine sich ändernde Kompensationsgleichspannung abgibt, und danach in einen zweiten Betriebszustand, in dem sie konstant die zum Zeitpunkt des Verlassens des ersten Betriebszustandes erreichte Kompensationsgleichspannung liefert, steuerbar ist;
e) und eine Kompensationssteuerschaltung (37), mittels welcher der Schaltzustand der Schaltereinrichtung (S1 - S3) steuerbar und die Kompensationsspannungsquelle (53, 65) zu Beginn eines Offset-Kompensationsvorgangs in ihren ersten Betriebs zustand schaltbar ist;
f) wobei die Kompensationsspannungsquelle (53, 65) bei Feststellung eines Spannungswertes Null durch den Nullspannungsdetektor (57) in ihren zweiten Betriebszustand schaltbar ist;
**dadurch gekennzeichnet, dass**
g) der Ausgang der Addiereinrichtung (45) direkt mit dem Eingang des Nullspannungsdetektors (57) verbunden ist;
h) es sich bei der ersten Ausgangsspannung um die Ausgangsspannung der Offset-behafteten Schaltungsanordnung (15, 17), bei der zweiten Ausgangsspannung um die Ausgangsspannung der Addiereinrichtung (45) und bei der sich ändernden Kompensationsgleichspannung um eine ansteigende oder abfallende Kompensationsgleichspannung handelt; und
i) der Nullspannungsdetektor (57) die Ausgangsspannung am Ausgang (55) der Addiereinrichtung (45) auf den Spannungswert Null überwacht.

2. Signalverarbeitungsschaltung nach Anspruch 1, bei welcher in dem Signalweg der Signalverarbeitungsschaltung vor der Offset-behafteten Schaltungsanordnung (15, 17) ein erster steuerbarer Schalter (S1) und nach der Offset-behafteten Schaltungsanordnung (15,17) ein zweiter steuerbarer Schalter (S2) angeordnet sind und die Addiereinrichtung (45) zwischen der Offset-behafteten Schaltungsanordnung (15, 17) und dem zweiten steuerbaren Schalter (S2) angeordnet ist, wobei die beiden Schalter (S1, S2) der je nachfolgenden Schaltungseinrichtung (17 bzw. 35) in einem ersten Schaltzustand das zu verarbeitende Signal und in einem zweiten Schaltzustand ein Nullpotential, wie Massepotential, zuführen.

3. Signalverarbeitungsschaltung nach Anspruch 2, bei welcher die Addiereinrichtung (45) aufweist:
a) einen ersten Addierereingang (47), der mit dem Ausgang der Offset-behafteten Schaltungsanordnung (15, 17) gekoppelt ist,
b) einen zweiten Addierereingang (49), der mit einem Kompensationsspannungsausgang (51) der Kompensationsspannungsquelle (53, 65) gekoppelt ist, und
c) einen Addiererausgang (55), der einerseits mit dem zweiten Schalter (S2) und andererseits mit einem Eingang (56) des Nullspannungsdetektors (57) gekoppelt ist.

4. Signalverarbeitungsschaltung nach Anspruch 2 oder 3, bei welcher
a) die Kompensationssteuerschaltung (37) durch ein Offset-Kompensationsbefehlssignal in einen Offset-Kompensationsbetrieb steuerbar ist, in dem sie die beiden steuerbaren Schalter (S1, S2) je in deren zweiten Schaltzustand und die Kompensationsspannungsquelle (53, 65) in deren ersten Betriebszustand steuert, und
b) vom Nullspannungsdetektor (57) bei der Feststellung eines Spannungswertes Null am Addiererausgang (55) ein Stopsignal erzeugbar ist, auf welches hin die Kompensationsspannungs quelle (53, 65) in ihren zweiten Betriebszustand und die beiden steuerbaren Schalter (S1, S2) je in deren ersten Schaltzustand steuerbar sind.

5. Signalverarbeitungsschaltung nach einem der Ansprüche 2 bis 4, die als Audiosignalverarbeitungsschaltung ausgebildet ist und eine Reihenschaltung mit einem Offset-behafteten Stereodecoder (17) und einem Offset-behafteten Signalverstärker (15) aufweist, wobei diese Reihenschaltung zwischen dem ersten steuerbaren Schalter (S1) und der Addiereinrichtung (45) angeordnet ist.

6. Signalverarbeitungsschaltung nach Anspruch 5,
mit einer Signalquellenauswahlschaltung (11), mittels welcher von einer Anzahl unterschiedlicher Audiosignalquellen, die mindestens eine Offset-behaftete Signalquelle, wie den Stereodecoder (17), und Offset-freie Signalquellen, beispielsweise Eingangsanschlüsse für einen Cassettenrekorder, einen CD-Spieler und eine AM-Signalquelle, umfassen, jeweils eine mit einem Signaleingang (+) des Signalverstärkers (15) verbindbar ist,
wobei die Schaltereinrichtung einen dritten steuerbaren Schalter (S3) aufweist, der in dem Signalweg zwischen der Signalquellenauswahlschaltung (11) und dem Signaleingang (+) des Signalverstärkers (15) angeordnet ist und dem Signaleingang (+) des Signalverstärkers (15) in einem ersten Schaltzustand das zu verarbeitende Signal und in einem zweiten Schaltzustand das Nullpotential zuführt, wobei der dritte Schalter (S3) während eines Offset-Kompensationsvorganges in den ersten Schaltzustand schaltbar ist, wenn die Signalquellenauswahlschaltung (11) den Signaleingang (+) des Signalverstärkers (15) mit einer Offset-behafteten Signalquelle (17) verbindet, und in den zweiten Schaltzustand schaltbar ist, wenn die Signalquellenauswahlschaltung (11) den Signaleingang des Signalverstärkers (+) mit einer Offset-freien Signalquelle verbindet.

7. Signalverarbeitungsschaltung nach einem der Ansprüche 1 bis 6, bei welcher die Kompensationsspannungsquelle (53, 65) aufweist:
a) einen mit Zähltakten (TAKT) beaufschlagbaren Zähler (65), der zu Beginn eines Offset-Kompensationsvorgangs auf einen vor bestimmten Anfangszählwert einstellbar ist und dessen Zählwert während des ersten Betriebszustandes der Kompensationsspannungsquelle (53, 65) durch Zählen der Zähltakte (TAKT) veränderbar und während des zweiten Betriebszustandes der Kom pensationsspannungsquelle (53, 65) auf dem zum Zeitpunkt des Verlassens des ersten Betriebszustandes erreichten Zählwert festhaltbar ist, und
b) einen Digital/Analog-Wandler (53), mittels welchem der jeweilige Zählstand des Zählers (65) in einen analogen Kompensationsgleichspannungswert umwandelbar ist.

8. Signalverarbeitungsschaltung nach Anspruch 6 oder 7, bei welcher die Kompensationssteuerschaltung (37) einen Steuersignaleingang (39) aufweist, dem gleichzeitig wie der Signalquellenauswahlschaltung (11) ein der Signalquellenumschaltung dienendes Signalquellenumschaltsteuersignal zuführbar ist,
wobei mittels des Signalquellenumschaltsteuersignals von der Kompensationssteuerschaltung (37) im wesentlichen gleichzeitig eine Umschaltung
a) der Schaltereinrichtung (S1 - S3) in deren für einen Offset-Kompensationsvorgang vorgesehenen Schaltzustand
b) und der Kompensationsgleichspannungsquelle (53, 65) in deren ersten Betriebszustand steuerbar ist.

9. Signalverarbeitungsschaltung nach Anspruch 8, bei welcher ein Datenregister (31) vorgesehen ist, in das beim Erhalt des Signalquellenumschaltsteuersignals ein der ausgewählten Signalquelle zugehöriges Datenwort einspeicherbar ist, mittels welchem die jeweilige Signalquellenauswahl bis zum Einlesen eines neuen Datenwortes in das Datenregister (31) aufrechterhalbar ist.

10. Signalverarbeitungsschaltung nach einem der Ansprüche 7 bis 9, bei welcher der Zähler (65) einen Stopsignaleingang (69) aufweist, dem das Stopsignal (STOP) des Nullspannungsdetektors (57) zuführbar ist, und der Zähler (67) dazu ausgebildet ist, bei dem beim Empfang des Stopsignals (STOP) erreichten Zählwert stehen zu bleiben, bis der Zähler (65) von der Steuereinrichtung (37) erneut auf seinen Anfangszählwert gesetzt wird.

11. Signalverarbeitungsschaltung nach Anspruch 10, bei welcher die Steuereinrichtung (37) einen Stopsignaleingang aufweist, dem das Stopsignal (STOP) des Nullspannungsdetektors (57) zuführbar ist, und die Steuereinrichtung (37) dazu ausgebildet ist, beim Empfang des Stopsignals (STOP) die Schaltereinrichtung (S1 - S3) in den signalleitenden Schaltzustand zu steuern.

## Claims

1. An electric signal processing circuit in whose signal path a circuit configuration with offset (15, 17) is located, wherein the following are provided for offset compensation:
a) a switch device (S1-S3) for switching the circuit configuration with offset (15, 17) temporarily into a compensation operating state in which it is decoupled from the signal path of the signal processing circuit and held strictly in a dc mode;
b) an adding device (45) for adding an offset compensating voltage to the output voltage of the circuit configuration with offset (15, 17);
c) a zero voltage detector (57) for monitoring the output voltage of the adding device (45) for the occurrence of a zero voltage;
d) a compensating voltage source (53, 65) which is switched at the beginning of an offset compensating process first into a first operating state in which it gives out a varying compensating direct voltage, and then into a second operating state in which it constantly supplies the compensating direct voltage reached at the time it left the first operating state;
e) and a compensating control circuit (37) for controlling the switching state of the switch device (S1-S3) and switching the compensating voltage source (53, 65) into its first operating state at the beginning of an offset compensating process;
f) the compensating voltage source (53, 65) being switched into its second operating state upon detection of a zero voltage at the output (55) of the adding device (45) by the zero voltage detector (57); **characterized in that**
g) the output of the adding device (45) is connected directly to the input of the zero voltage detector (57);
h) the first output voltage is the output voltage of the circuit configuration with offset (15, 17), the second output voltage is the output voltage of the adding device (45), and the varying compensating direct voltage is a rising or falling compensating direct voltage; and
i) the zero voltage detector (57) monitors the output voltage at the output (55) of the adding device (45) for zero voltage.

2. The signal processing circuit of claim 1, wherein a first controllable switch (S1) is disposed in the signal path of the signal processing circuit before the circuit configuration with offset (15, 17), and a second controllable switch (S2) after the circuit configuration with offset (15, 17), and the adding device (45) is disposed between the circuit configuration with offset (15, 17) and the second controllable switch (S2), the two switches (S1, S2) supplying to the particular following circuit device (17, 35) the signal to be processed in a first switching state and a zero potential, such as ground potential, in a second switching state.

3. The signal processing circuit of claim 2, wherein the adding device (45) comprises:
a) a first adder input (47) coupled with the output of the circuit configuration with offset (15, 17),
b) a second adder input (49) coupled with a compensating voltage output (51) of the compensating voltage source (53, 65), and
c) an adder output (55) coupled with the second switch (S2), on the one hand, and with an input (56) of the zero voltage detector (57), on the other hand.

4. The signal processing circuit of claim 2 or 3, wherein
a) the compensating control circuit (37) is switched by an offset compensating command signal into an offset compensating operation in which it switches the two controllable switches (S1, S2) into their second switching state and the compensating voltage source (53, 65) into its first operating state, and
b) the zero voltage detector (57), upon detection of a zero voltage at the adder output (55), produces a stop signal which causes the compensating voltage source (53, 65) to switch into its second operating state and the two controllable switches (S1, S2) into their first switching state.

5. The signal processing circuit of any of claims 2 to 4, which is formed as audio signal processing circuit and has a series connection with a stereo decoder with offset (17) and a signal amplifier with offset (15), this series connection being disposed between the first controllable switch (S1) and the adding device (45).

6. The signal processing circuit of claim 5, having a signal source selection circuit (11) for connecting with a signal input (+) of the signal amplifier (15) one of a number of different audio signal sources including at least one signal source with offset, such as the stereo decoder (17), and signal sources without offset, for example input connections for a cassette recorder, a compact disc player and an AM signal source,
the switch device having a third controllable switch (S3) disposed in the signal path between the signal source selection circuit (11) and the signal input (+) of the signal amplifier (15), and supplying to the signal input (+) of the signal amplifier (15) the signal to be processed in a first switching state and the zero potential in a second switching state, the third switch (S3) being switched into the first switching state during an offset compensating process when the signal source selection circuit (11) connects the signal input (+) of the signal amplifier (15) with a signal source with offset (17), and being switched into the second switching state when the signal source selection circuit (11) connects the signal input (+) of the signal amplifier with a signal source without offset.

7. The signal processing circuit of any of claims 1 to 6, wherein the compensating voltage source (53, 65) comprises:
a) a counter (65) subject to counting clocks (CLOCK) which is adjusted at the beginning of an offset compensating process at a predetermined initial count number, and whose count number is varied by the counting of the counting clocks (CLOCK) during the first operating state of the compensating voltage source (53, 65) and held at the count number reached at the time it left the first operating state during the second operating state of the compensating voltage source (53, 65), and
b) a digital-to-analog converter (53) for converting the particular count of the counter (65) into an analog compensating dc voltage.

8. The signal processing circuit of claim 6 or 7, wherein the compensating control circuit (37) has a control signal input (39) which is supplied simultaneously with the signal source selection circuit (11) a signal source switchover control signal serving to switch over the signal source, the signal source switchover control signal causing the compensating control circuit (37) to control essentially simultaneously a switchover of
a) the switch device (S1-S3) into its switching state intended for an offset compensating process
b) and the compensating direct voltage source (53, 65) into its first operating state.

9. The signal processing circuit of claim 8, wherein a data register (31) is provided for storing a data word belonging to the selected signal source upon reception of the signal source switchover control signal, said data word serving to maintain the particular signal source selection until a new data word is read into the data register (31).

10. The signal processing circuit of any of claims 7 to 9, wherein the counter (65) has a stop signal input (69) which is supplied the stop signal (STOP) from the zero voltage detector (57), and the counter (67) is designed to stop at the count number reached upon reception of the stop signal (STOP) until the counter (65) is reset to its initial count number by the control device (37).

11. The signal processing circuit of claim 10, wherein the control device (37) has a stop signal input which is supplied the stop signal (STOP) from the zero voltage detector (57), and the control device (37) is designed to switch the switch device (S1-S3) into the signal-conducting switching state upon reception of the stop signal (STOP).

## Revendications

1. Circuit électrique de traitement de signal comprenant un circuit présentant un offset (15, 17), dans lequel il est prévu, pour la compensation d'offset :
a) un dispositif commutateur (S1-S3), au moyen duquel le circuit présentant un offset (15, 17) est commutable de façon temporaire dans un mode de compensation dans lequel il est déconnecté de la voie empruntée par le signal dans le circuit de traitement et est maintenu dans un mode opératoire à tension continue ;
b) un dispositif additionneur (45), au moyen duquel une tension de compensation d'offset peut être additionnée à une première tension de sortie ;
c) un détecteur de tension nulle (57), au moyen duquel une deuxième tension de sortie peut être surveillée quant à l'apparition d'une valeur de tension nulle ;
d) une source de tension de compensation (53, 65), qui peut être commandée au début d'un processus de compensation d'offset d'abord dans un premier état de fonctionnement, dans lequel elle fournit une tension continue de compensation variable, et ensuite dans un deuxième état de fonctionnement, dans lequel elle fournit de manière constante la tension continue de compensation atteinte lorsque le premier état de fonctionnement a été quitté ;
e) et un circuit de commande de compensation (37), au moyen duquel l'état de commutation du dispositif commutateur (S1-S3) peut être commandé et la source de tension de compensation (53, 65) peut être commutée dans son premier état de fonctionnement au début d'un processus de compensation d'offset ;
f) dans lequel la source de tension de compensation (53, 65) peut être commutée dans son deuxième état de fonctionnement lorsqu'une valeur de tension nulle est détectée par le détecteur de tension nulle (57) ;
**caractérisé en ce que**
g) la sortie du dispositif additionneur (45) est reliée directement à l'entrée du détecteur de tension nulle (57) ;
h) la première tension de sortie correspond à la tension de sortie du circuit présentant un offset (15, 17), la deuxième tension de sortie correspond à la tension de sortie du dispositif additionneur (45) et la tension continue de compensation variable correspond à une tension continue de compensation croissante ou décroissante ; et
i) le détecteur de tension nulle (57) surveille la tension de sortie à la sortie (55) du dispositif additionneur (45) pour détecter une valeur de tension nulle.

2. Circuit de traitement de signal selon la revendication 1, dans lequel un premier commutateur commandable (S1) est agencé dans la voie suivie par le signal dans le circuit de traitement de signal avant le circuit présentant un offset (15, 17), un deuxième commutateur commandable (S2) est agencé après le circuit présentant un offset (15, 17), et le dispositif additionneur (45) est agencé entre le dispositif présentant un offset (15, 17) et le deuxième commutateur commandable (S2), les deux commutateurs (S1, S2) transmettant le signal à traiter au circuit suivant (17, respectivement 35) dans un premier état de commutation et un potentiel nul, comme le potentiel de la masse, dans un deuxième état de commutation.

3. Circuit de traitement de signal selon la revendication 2, dans lequel le dispositif additionneur (45) comporte :
a) une première entrée (47), couplée à la sortie du dispositif présentant un offset (15, 17),
b) une deuxième entrée (49), couplée à une sortie de tension de compensation (51) de la source de tension de compensation (53, 65), et
c) une sortie (55), couplée d'une part au deuxième commutateur (S2) et d'autre part à une entrée (56) du détecteur de tension nulle (57).

4. Circuit de traitement de signal selon la revendication 2 ou 3, dans lequel :
a) le circuit de commande de compensation (37) peut être commandé dans un mode de compensation d'offset par un signal de commande de compensation d'offset, mode dans lequel il commande les deux commutateurs commandables (S1, S2) dans leur deuxième état de commutation et la source de tension de compensation (53, 65) dans son premier état de fonctionnement, et
b) un signal d'arrêt peut être fourni par le détecteur de tension nulle (57) lors de la détection d'une valeur nulle de tension à la sortie du dispositif additionneur (55), signal d'arrêt grâce auquel la source de tension de compensation (53, 65) peut être commandée dans son deuxième état de fonctionnement et les deux commutateurs commandables (S1, S2) dans leur premier état de commutation.

5. Circuit de traitement de signal selon une des revendications 2 à 4, réalisé sous forme de circuit de traitement de signal audio et comprenant un circuit série comportant un décodeur stéréo présentant un offset (17) et un amplificateur de signal présentant un offset (15), dans lequel le circuit série est agencé entre le premier commutateur commandable (S1) et le dispositif additionneur (45).

6. Circuit de traitement de signal selon la revendication 5, comportant un circuit de sélection de sources de signal (11) permettant de relier, à une entrée de signal (+) de l'amplificateur (15), une de plusieurs sources de signal audio différentes comprenant au moins une source de signal présentant un offset, comme le décodeur stéréo (17), et des sources de signal libres d'offset, par exemple des bornes d'entrée pour un enregistreur à cassette, un lecteur CD et une source de signal AM,
dans lequel le dispositif commutateur comporte un troisième commutateur commandable (S3) agencé dans la voie empruntée par le signal entre le circuit de sélection de sources de signal (11) et l'entrée de signal (+) de l'amplificateur (15) et transmettant le signal à traiter à l'entrée de signal (+) de l'amplificateur (15) dans un premier état de commutation, et le potentiel nul dans un deuxième état de commutation, dans lequel le troisième commutateur (S3) peut être commuté dans le premier état de commutation pendant un processus de compensation d'offset, lorsque le circuit de sélection de sources de signal (il) relie l'entrée de signal (+) de l'amplificateur (15) à une source de signal présentant un offset (17), et dans un deuxième état de commutation lorsque le circuit de sélection de sources de signal (11) relie l'entrée de signal (+) de l'amplificateur à une source de signal libre d'offset.

7. Circuit de traitement de signal selon une des revendications 1 à 6, dans lequel la source de tension de compensation (53, 65) comporte :
a) un compteur (65) piloté par des impulsions de comptage (TAKT), ajustable au début d'un processus de compensation d'offset à une valeur initiale de comptage prédéterminée, la valeur de comptage du compteur pouvant être modifiée lors du premier état de fonctionnement de la source de tension de compensation (53, 65) par le comptage des impulsions de comptage (TAKT) et être maintenue, lors du deuxième état de fonctionnement de la source de tension de compensation (53, 65), à la valeur de comptage atteinte au moment où est quitté le premier état de fonctionnement, et
b) un convertisseur numérique/analogique (53), au moyen duquel l'état de comptage du compteur (65) peut être transformé en une valeur analogique de tension continue de compensation.

8. Circuit de traitement de signal selon la revendication 6 ou 7, dans lequel le circuit de commande de compensation (37) comporte une entrée de signal de commande (39) pouvant recevoir, en même temps que le circuit de sélection de sources de signal (11), un signal de commande de commutation des sources de signal, dans lequel le circuit de commande de compensation (37) peut réaliser sensiblement en même temps, au moyen du signal de commande de commutation des sources de signal :
a) une commutation du dispositif commutateur (S1-S3) dans son état de commutation prévu pour un processus de compensation d'offset
b) et une commutation de la source de tension continue de compensation (53, 65) dans son premier état de fonctionnement.

9. Circuit de traitement de signal selon la revendication 8, dans lequel un registre de données (31) est prévu et un mot de données associé à la source de signal choisie peut être emmagasiné dans le registre lorsque le signal de commande de commutation de sources de signal est fourni, mot au moyen duquel le choix de la source de signal peut être conservé jusqu'à ce qu'un nouveau mot de données soit mémorisé dans le registre de données (31).

10. Circuit de traitement de signal selon une des revendications 7 à 9, dans lequel le compteur (65) comporte une entrée de signal d'arrêt (69) à laquelle le signal d'arrêt (STOP) du détecteur de tension nulle (57) peut être fourni, et le compteur (65) est réalisé de façon à rester à la valeur de comptage atteinte lors de la réception du signal d'arrêt (STOP), jusqu'à ce que le compteur (65) soit à nouveau remis à sa valeur de comptage initiale par le dispositif de commande (37).

11. Circuit de traitement de signal selon la revendication 10, dans lequel le dispositif de commande (37) présente une entrée de signal d'arrêt à laquelle le signal d'arrêt (STOP) du détecteur de tension nulle (57) est fourni, et le dispositif de commande (37) est réalisé de façon à commander le dispositif de commutateur (S1-S3) à l'état de commutation passant à la réception du signal d'arrêt (STOP).
